# EUROPEAN PATENT APPLICATION

(11) **EP 4 333 019 A1**
(43) Date of publication of application: **06.03.2024**
(21) Application number: 22193743.6
(22) Date of filing: 02.09.2022
(51) Int. Cl.: H01J 37/26, H01J 37/28

(54) **CHARGED PARTICLE ASSESSMENT SYSTEM AND METHOD**

(71) Applicant: ASML Netherlands B.V., 5500 AH Veldhoven (NL)
(72) Inventor: WIELAND, Marco, Jan-Jaco, 5500 AH Veldhoven (NL); KUIPER, Vincent, Sylvester, 5500 AH Veldhoven (NL); TSIATMAS, Anagnostis, San Jose, 95134 (US)
(74) Representative: ASML Netherlands B.V.

(57) **Abstract**

An assessment method comprising: using an assessment apparatus to generate assessment signals representing a property of a surface of a sample; processing the assessment signals to identify candidate defects and outputting a candidate defect signal; monitoring the status of the assessment apparatus for error conditions and generating a status signal indicating any error conditions during functioning of the assessment apparatus; and analysing the candidate defect signal to determine if the candidate defects are real defects; wherein analysis of a candidate defect is not completed if the status signal indicates that the assessment signal(s) and/or the candidate defect signal corresponding to the candidate defect would have been affected by an error condition.

## Description

### FIELD

The embodiments provided herein generally relate to charged particle assessment systems and methods of operating charged particle assessment systems.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the inspection and/or measurement of a surface of a substrate, or other object/material, is an important process during and/or after its manufacture.

Pattern inspection apparatuses with a charged particle beam have been used to inspect objects, which may be referred to as samples, for example to detect pattern defects. These apparatuses typically use electron microscopy techniques, such as a scanning electron microscope (SEM). In a SEM, a primary electron beam of electrons at a relatively high energy is targeted with a final deceleration step in order to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons, which may be referred more generally signal particles. The signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection apparatus may obtain an image representing characteristics of the material structure of the surface of the sample.

When a pattern inspection apparatus is used to detect defects on samples at a high throughput, a very large amount of image data is generated and must be processed to detect defects. In particular it is desirable to reduce noise in image data. US 8,712,184 B1 and US 9,436,985 B1 describe methods of reducing noise or improving signal-to-noise ratio in images obtained from scanning electron microscopes. It is necessary to distinguish noise such as nuisance signals from genuine defects (or real defects), otherwise an excessive proportion of processed substrates might be rejected, unnecessarily reducing yield. Some noise can be eliminated by statistical means and applying thresholds but such techniques cannot distinguish all noise such as some nuisance signals, from genuine defects. Therefore, there remains a need for improved techniques to distinguish noise from genuine defects and reduce false positives.

### SUMMARY

It is an object of the present disclosure to provide embodiments that avoid or ameliorate undesirable data imperfections impacting performance of charged particle assessment apparatus used to detect defects.

According to an aspect of the invention, there is provided an assessment method comprising: using an assessment apparatus to generate assessment signals representing a property of a surface of a sample; processing the assessment signals to identify candidate defects and outputting a candidate defect signal; monitoring the status of the assessment apparatus for error conditions and generating a status signal indicating any error conditions during functioning of the assessment apparatus; and analysing the candidate defect signal to determine if the candidate defects are real defects; wherein analysis of a candidate defect is not completed if the status signal indicates that the assessment signal(s) and/or the candidate defect signal corresponding to the candidate defect would have been affected by an error condition.

According to an aspect of the invention, there is provided an assessment method comprising: using an assessment apparatus to generate assessment signals representing a property of a surface of a sample; processing the assessment signals to identify candidate defects and outputting a candidate defect signal; monitoring the status of the assessment apparatus for error conditions and generating a status signal indicating an occurrence of any error conditions during functioning of the assessment apparatus; and analysing the candidate defect signal to determine if the candidate defects are real defects; wherein in analysis of a candidate defect comprises using a status signal to verify that the assessment signal(s) and/or the candidate defect signal corresponding to the candidate defect would have been affected by an error condition and stopping analysis of the defect candidate on verification.

An assessment system comprising: a detector unit configured to generate assessment signals representing a property of a surface of a sample; a data processor configured to process the assessment signals to identify candidate defects and to output a candidate defect signal; a status monitor configured to monitor the status of the assessment system for error conditions and to generate a status signal indicating an occurrence of any error conditions during functioning of the assessment system; and an analysis unit configured to analyse the candidate defect signal to determine if the candidate defects are real defects; wherein the analysis unit is configured to stop analysis of a candidate defect prior to completion if the status signal indicates that the assessment signal(s) and/or the candidate defect signal corresponding to the candidate defect would have been affected by an error condition.

According to an aspect of the invention, there is provided anassessment system comprising: a detector unit configured to generate assessment signals representing a property of a surface of a sample; a data processor configured to process the assessment signals to identify candidate defects and to output a candidate defect signal; a status monitor configured to monitor the status of the assessment system for error conditions and to generate a status signal indicating an occurrence of any error conditions during functioning of the assessment apparatus; and an analysis unit configured to analyse the candidate defect signal to determine if the candidate defects are real defects; wherein the analysis unit is configured to stop analysis of a candidate defect prior to completion if verification using the status signal indicates that the assessment signal(s) and/or the candidate defect signal corresponding to the candidate defect would have been affected by an error condition.

According to an aspect of the invention, there is provided a data processing apparatus for analysing candidate defects to identify real defects, the data processing apparatus comprising: an interface configured to receive from an assessment apparatus a candidate defect signal representing candidate defects and a status signal indicating any error conditions during functioning of the assessment apparatus; an analysis unit configured to analyse the candidate defect signal to identify real defects; wherein the analysis unit is configured to stop analysis of a candidate defect prior to completion if the status signal indicates that the candidate defect signal corresponding to the candidate defect would have been affected by an error condition.

According to an aspect of the invention, there is provided a data processing method for analysing candidate defects to identify real defects, the method comprising: receiving from an assessment apparatus a candidate defect signal representing candidate defects and a status signal indicating any error conditions during functioning of the assessment apparatus; analysing the candidate defect signal to identify real defects; wherein the analysing of a candidate defect is stopped prior to completion if the status signal indicates that the candidate defect signal corresponding to the candidate defect would have been affected by an error condition.

According to an aspect of the invention, there is provided a charged particle assessment system for detecting defects in samples by relatively scanning a plurality of charged particle beams, for example in beam grid, and a sample so the grid passes over the surface; the apparatus comprising: detector unit comprising a plurality of detector elements and configured to output a detection signal in response to signal particles incident from a sample resulting from and associated with the different beams of the beam grid; a signal processor configured to process the detection signal to generate an assessment signal, the assessment signal including property information relating to, for each detector element, a property of the sample and a detection time of detection of signal particles; and an analysis unit configured to analyse the assessment signal to identify defect candidates on the sample based on analysis of property information for each detector element in the assessment signal; wherein the analysis unit is configured to analyse the property information from different detector elements to determine an error state associated with one more beams of the beam grid.

According to an aspect of the invention, there is provided a method for detecting defects in samples in a charged particle assessment apparatus for projecting a charged particle beam towards a sample, the method comprising: relatively scanning a charged particle beam and a surface of a sample so the beam passes over the surface in the charged particle assessment apparatus; outputting a detection signal from a detector of the charged particle assessment apparatus in response to signal particles from a sample, the detection signal having a time record relative to a timeline; emitting a status signal having a time stamp relative the timeline, the status signal indicating a status of the charged particle assessment apparatus, the status comprising a transient error affecting operation of the assessment apparatus; processing the detection signal when the time record indicates a different time than the time stamp of the transient error.

According to an aspect of the invention, there is provided a charged particle assessment system for detecting defects in samples by relatively scanning a plurality of charged particle beams in beam grid and a sample so the grid passes over the surface; the apparatus comprising: a detector unit comprising a plurality of detector elements and configured to output a detection signal in response to signal particles incident from a sample resulting from and associated with the different beams of the beam grid; a controller configured to control the charged particle assessment system to determine failure of one more beams of the beam grid and identifying the beam identify of the failed beams; and based on the beam identity of the failed beams removing the detection signals of failed beams, or information derived from the detection signals of failed beams, from processing and/or analysing for determining candidate defects on the sample surface.

According to an aspect of the invention, there is provided a method for detecting defects in samples in a charged particle assessment apparatus for projecting a charged particle beam towards a sample, the method comprising: relatively scanning a charged particle beam and a surface of a sample so the beam passes over the surface in the charged particle assessment apparatus; outputting a detection signal from a detector of the charged particle assessment apparatus in response to signal particles from a sample, the detection signal having a time record relative to a timeline; emitting a status signal having a time stamp relative the timeline, the status signal indicating a status of the charged particle assessment apparatus, the status comprising a transient error affecting operation of the assessment apparatus; processing the detection signal when the time record indicates a different time than the time stamp of the transient error.

According to an aspect of the invention, there is provided a charged particle assessment system for detecting defects in samples by relatively scanning a plurality of charged particle beams in beam grid and a sample so the grid passes over the surface; the apparatus comprising: a detector unit comprising a plurality of detector elements and configured to output a detection signal in response to signal particles incident from a sample resulting from and associated with the different beams of the beam grid; a controller configured to control the charged particle assessment system to determine failure of one more beams of the beam grid and identifying the beam identify of the failed beams; and based on the beam identity of the failed beams removing the detection signals of failed beams, or information derived from the detection signals of failed beams, from processing and/or analysing for determining candidate defects on the sample surface.

According to an aspect of the invention, there is provided an assessment method comprising: using an assessment apparatus to generate assessment signals representing a property of a surface of a sample; processing the assessment signals to identify candidate defects and outputting a candidate defect signal; monitoring the status of the assessment apparatus for error conditions and generating a status signal indicating an occurrence of any error conditions and an operational status otherwise, the occurrence occurring during functioning of the assessment apparatus that would have affected an assessment signal generated during the occurrence and/or the candidate defect signal corresponding to the candidate defect and being derived from the assessment signal; and analysing the candidate defect signal to determine if the candidate defects are real defects; wherein analysis of a candidate defect is completed only if the status signal indicates an operational status.

According to an aspect of the invention, there is provided an assessment system comprising: a detector unit configured to generate assessment signals representing a property of a surface of a sample; a data processor configured to process the assessment signals to identify candidate defects and to output a candidate defect signal; a status monitor configured to monitor the status of the assessment system for error conditions and to generate a status signal indicating an occurrence of any error conditions and an operational status otherwise, the occurrence occurring during functioning of the assessment apparatus that would have affected an assessment signal generated during the occurrence and/or the candidate defect signal corresponding to the candidate defect and being derived from the assessment signal; and wherein the analysis unit is configured to complete analysis of a candidate defect only if the status signal indicates an operational status.

According to an aspect of the invention, there is provided a computer program comprising instructions interpretable by a computer that controls an assessment apparatus, the computer program comprising instructions to perform a method according to another aspect of the invention disclosed herein.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam assessment system.
**FIG. 2** is a schematic diagram illustrating an exemplary multi-beam charged particle assessment apparatus that is part of the exemplary charged particle beam assessment system of **FIG. 1**.
**FIG. 3** is a schematic diagram of a data path according to an embodiment.
**FIG. 4** is a schematic diagram of a status monitoring system of an embodiment of the invention.
**FIG. 5** is a flow chart of a method of the invention.

The schematic diagrams and views show the components described below. However, the components depicted in the figures are not to scale.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000th of a human hair. Thus, it is not surprising that semiconductor IC manufacturing is a complex and time-consuming process, with hundreds of individual steps. Errors in even one step have the potential to dramatically affect the functioning of the final product. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection devices (such as a Scanning Electron Microscope ('SEM')) is essential for maintaining high yield and low cost.

An embodiment of a SEM comprises a scanning device and a detector apparatus. The scanning device comprises an illumination apparatus that comprises an electron source, for generating primary electrons (or charged particles), and a projection apparatus for scanning a sample, such as a substrate, with one or more focused beams (or a plurality of beams) of primary electrons. The plurality of beams may be arranged as a multi-beam, The plurality of beams may have a multi-beam arrangement (which may have the form of a grid) which may be directed along a multi-beam path towards a sample. Together at least the illumination apparatus, or illumination system, and the projection apparatus, or projection system, may be referred to together as the electron-optical system or apparatus. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

While the description and drawings are directed to an electron-optical system, it is appreciated that the embodiments are not used to limit the present disclosure to specific charged particles. References to electrons throughout the present document may therefore be more generally be considered to be references to charged particles, with the charged particles not necessarily being electrons. The present invention can also be applied to optical inspection systems such as optical microscopes and optical scatterometers.

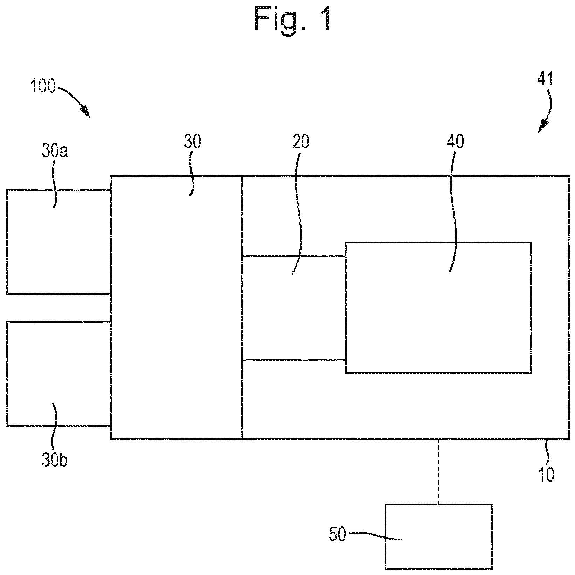

Reference is now made to **FIG. 1**, which is a schematic diagram illustrating an exemplary charged particle beam assessment system 100 (or simply an assessment system, which may also be referred to as a charged particle beam inspection system or simply inspection system or a charged particle metrology system or simply a metrology system. The charged particle beam assessment system 100 of **FIG. 1** includes a main chamber 10, a load lock chamber 20, an electron beam apparatus 40, an equipment front end module (EFEM) 30 and a controller 50. The electron beam apparatus 40 is located within the main chamber 10.

The EFEM 30 includes a first loading port 30a and a second loading port 30b. The EFEM 30 may include additional loading port(s). The first loading port 30a and the second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in the EFEM 30 transport the samples to the load lock chamber 20.

The load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from the load lock chamber 20 to the main chamber 10. The main chamber 10 is connected to a main chamber vacuum pump system (not shown). The main chamber vacuum pump system removes gas particles in the main chamber 10 so that the pressure in around the sample reaches a second pressure lower than the first pressure. After reaching the second pressure, the sample is transported to the electron beam system by which it may be inspected. An electron beam apparatus 40 may comprise a multi-beam electron-optical apparatus (which may be referred to an electron-optical column or device).

The controller 50 is electronically connected to electron beam apparatus 40. The controller 50 may be a processor (such as a computer) configured to control the charged particle beam assessment system 100. The controller 50 may also include circuitry which may be referred to as processing circuitry configured to execute various signal and image processing functions. While the controller 50 is shown in **FIG. 1** as being outside of the structure that includes the main chamber 10, the load lock chamber 20, and the EFEM 30, it is appreciated that the controller 50 may be part of the structure. The controller 50 may be located in one of the component elements of the charged particle beam inspection apparatus or it can be distributed over at least two of the component elements. While the present disclosure provides examples of the main chamber 10 housing an electron beam apparatus, it should be noted that aspects of the disclosure in their broadest sense are not limited to a chamber housing an electron beam apparatus. Rather, it is appreciated that the foregoing principles may also be applied to other devices, and other arrangements of apparatus, that operate under the second pressure. For example the controller may be a distributed controller having one or more parts at the second pressure, optionally with one more parts at the first pressure.

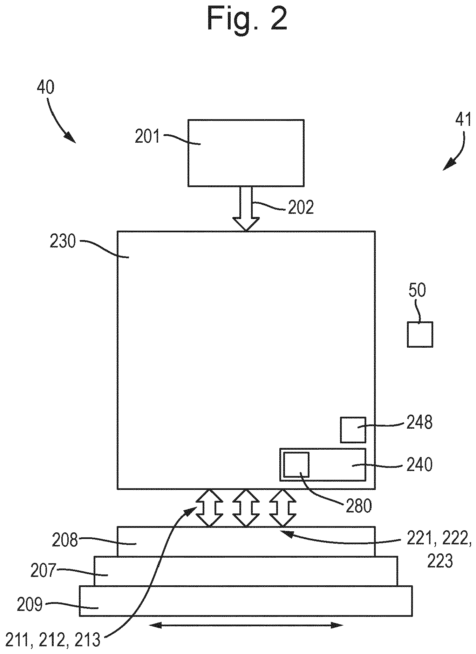

Reference is now made to **FIG. 2**, which is a schematic diagram illustrating an exemplary electron beam apparatus 40, including a multi-beam electron-optical device 41 (or column), that is part of the exemplary charged particle beam assessment system 100 of **FIG. 1**. The electron beam apparatus 40 comprises an electron source 201 and a projection apparatus 230. The electron beam apparatus 40 further comprises an actuated stage 209 and a sample holder 207. The actuated stage 209 and the sample holder 207 may be referred to as sub-systems respectively. The electron source 201 and projection apparatus 230 may together be referred to as the electron-optical device 41 or as an electron-optical column. The sample holder 207 is supported by actuated stage 209 so as to hold a sample 208 (e.g., a substrate or a mask) for inspection. The multi-beam electron-optical device 41 further comprises a detector 240 (e.g. an electron detection device).

The electron source 201 may comprise a cathode (not shown) and an extractor or anode (not shown). During operation, the electron source 201 is configured to emit electrons as primary electrons from the cathode. The primary electrons are extracted or accelerated by the extractor and/or the anode to form a primary electron beam 202.

The projection apparatus 230 is configured to convert the primary electron beam 202 into a plurality of sub-beams 211, 212, 213 and to direct each sub-beam onto the sample 208. Although three sub-beams are illustrated for simplicity, there may be many tens, many hundreds, many thousands for example approximately ten thousand, many tens of thousands or many hundreds of thousands of sub-beams. The sub-beams may be referred to as beamlets or just beams.

The controller 50 may be connected to various parts of the charged particle beam assessment system 100 of **FIG. 1**, such as the electron source 201, the detector 240, the projection apparatus 230, and the actuated stage 209 (e.g. a motorized stage). The controller 50 may perform various image and signal processing functions. The controller 50 may also generate various control signals to govern operations of the charged particle beam inspection apparatus, including the charged particle multi-beam apparatus.

The electron-optical apparatus 230 may be configured to focus sub-beams 211, 212, and 213 onto a sample 208 for inspection and may form probe spots 221, 222, and 223 (for this example three probe spots, one for each sub-beam) on the surface of sample 208. The projection apparatus 230 may be configured to deflect the primary sub-beams 211, 212, and 213 to scan the probe spots 221, 222, and 223 across individual scanning areas in a section of the surface of the sample 208. In response to incidence of the primary sub-beams 211, 212, and 213 on the probe spots 221, 222, and 223 on the sample 208, electrons are generated from the sample 208 which include secondary electrons and backscattered electrons which may be referred to as signal particles. The secondary electrons typically have electron energy less than or equal to 50 eV. Actual secondary electrons can have an energy of less than 5 eV, but anything beneath 50 eV is generally treated at a secondary electron. Backscattered electrons typically have electron energy between 0 eV and the landing energy of the primary sub-beams 211, 212, and 213. As electrons detected with an energy of less than 50 eV is generally treated as a secondary electron, a proportion of the actual backscatter electrons will be counted as secondary electrons.

The detector 240 is configured to detect signal particles such as secondary electrons and/or backscattered electrons and to generate corresponding detection signals which are sent to a signal processing system 280 for pre-processing, e.g. analog to digital conversion. The detector 240 may be part of a detector unit. The detector 240 may be incorporated into the projection apparatus 230. The detector unit may comprise a detector array. Further details and alternative arrangements of a detector module, sensor and detector array positioned proximate to up beam, down beam or otherwise integrated into an objective lens can be found in EP Application Number 20216890.2 and PCT Application number PCT/EP2021/068548, which documents are respectively is hereby incorporated by reference at least so far as details of the detector module, sensor and detector array and similar elements. Such a detector array may comprise an array of detector elements.

The detector may be provided with multiple portions and more specifically, multiple detecting portions. The detector comprising multiple portions may be associated with one of the sub-beams 211, 212, 213. Thus, the multiple portions of one detector 240 may be configured to detect signal particles emitted from the sample 208 in relation to one of the primary beams (which may otherwise be referred to as sub-beams 211, 212, 213). In other words, the detector comprising multiple portions may be associated with one of the apertures in at least one of the electrodes of the objective lens assembly. The multiple portions may be segments are arranged radially and/or angularly. More specifically, the detector comprising multiple portions may be arranged around a single aperture, which provides an examples of such a detector. As mentioned the detection signal from the detector module is used to generate an image. With multiple detecting portions, the detection signal comprises components from the different detecting signals that may be processed as data sets or in a detection image.

The objective lens may an objective lens array and may comprise a plurality of planar electrode or plates comprising apertures for the respective paths of the beams of the multi-beam. Each plate may extend across the multibeam arrangement. The objective lens may comprise at least two electrodes that may be connected to and controlled respective potentials. There may be additional plates each to control an additional degree of freedom. The detector may be a plate associated even connected to the objective lens with an aperture for each path of a beam of the beam of multi-beam. The detector may be located above, below or within the objective lens.

A scan deflector may be associated or even integrated into the objective lens for example as an array of scan deflectors. In an arrangement the scan deflector may be positioned up beam of the object lens. In an arrangement in which the path of the primary beams are collimated up beam of the objective lens, the scan deflectors may be positioned up beam of the objective lens. In an arrangement in which the multibeam is generated by a beam limiting aperture array of or associated with the objective lens from a collimated primary beam from a source, the scan deflector may be a macro scan deflector positioned up beam of the objective lens and so as to operate on the collimated primary beam. Other electron-optical arrangements may be envisaged comprising one or more elements herein described. Such scan deflectors may be controlled by the controller to deflect the beams of the multi-beam along one axis in the plane of the sample or both primary axes over the surface of a sample e.g. in the plane of the sample (which may be orthogonal with respect to each other).

It should be noted that embodiments of scan deflectors that are proximate to the sample, for example in being integrated or proximate to the objective lens, may have limited range of the scan deflection. However such proximate scan deflectors to the sample, may be accurately controlled and have a fast response relative to other types of scanning actuators such as an actuated stage.

The controller 50 may control the actuated stage 209 to move sample 208 during inspection of the sample 208. The controller 50 may enable the actuated stage 209 to move the sample 208 in a direction, for example continuously, for example at a constant speed, at least during sample assessment, which may be referred to as a type of scanning. The controller 50 may control movement of the actuated stage 209 so that it changes the speed of the movement of the sample 208 relative to the path of the multi-beam dependent on various parameters. The controller 50 may control deflection of the scan deflectors so that the path of the multibeam moves relative to the stage and thus over the sample surface. The controller 50 may change a beam deflection of the scan deflector and thus the scanning of the beams over the sample surface dependent on various parameter. For example, the controller 50 may control the stage speed (including its direction and during) and/or scan deflector depending on the characteristics of the inspection scanning elements and steps for example in the scanning process and/or scans of the scanning process for example as disclosed in EPA 21171877.0 filed 3 May 2021. The content of such application is hereby incorporated in so far as the combined stepping and scanning strategy at least of the stage and scanning deflectors.

References in this document to relatively scanning one or more charged particle beams and a sample are intended to cover any combination of moving the sample, e.g. by an actuated stage, and/or moving the beam, e.g. by a scan deflector, unless the context requires otherwise. An actuated stage may be actuated to move the sample relative to a beam path of the charged particle beam.

Known multi-beam systems, such as the electron beam apparatus 40 and charged particle beam assessment system 100 described above, are disclosed in US2020/118784, US202002/03116, US2019/0259564 and WO2021078352 which are hereby incorporated by reference. The present invention is also applicable in single beam systems.

The electron beam apparatus 40 may comprise a projection assembly to regulate accumulated charges on the sample by illuminating the sample 208.

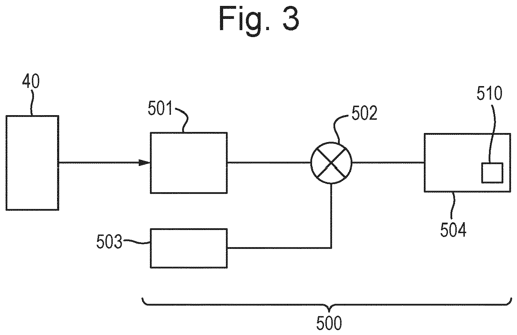

Images output from a charged particle assessment apparatus, e.g. electron beam apparatus 40, need to be processed automatically to detect defects in samples being assessed. A data processing apparatus (or device) 500 for detecting defects in images generated by a charged particle assessment device is depicted in **FIG. 3**. Data processing device 500, or at least a part of the data processing device 500, may be part of controller 50, part of another computer in the fab or integrated elsewhere in the charged particle assessment system 100, for example as part of the charged particle assessment apparatus 40, for example as part of the charged particle assessment device 41 such comprised in the detector unit. The controller may be a distributed controller or a plurality of controllers distributed through the charged particle assessment apparatus 40 or even the charged particle assessment system 100.

Various approaches may be taken to detect defects in images generated by a charged particle assessment device. A common approach is to compare an image of a part of the sample, referred to herein as a sample image, to a reference image. In practice, data points of a datastream representing the sample image are compared to data points of the reference image retrieved from a memory or delivered in a parallel data stream. For the sake of brevity, this process may be referred to below as comparing images and the data points as pixels. Any pixel that differs from the corresponding pixel of the reference image by more than a threshold amount may be considered a defect. Such a pixel that differs from the reference image, together with adjacent pixels that also differ from the reference image, is considered a single defect. (In an embodiment this may mean a pixel differing from the reference image and which has adjacent pixels which are the same as the reference image (i.e. do not differ from the reference image) can be considered to not represent a defect). The reference image may be obtained in various different ways, as discussed below.

The rate of false positives, i.e. samples being labelled as having defects when in fact no significant defect is present, can be controlled. The rate of false positives can be controlled by setting a threshold for determining the presence of a defect. The threshold may be the difference of the pixel compared to the reference image, e.g. compared to the equivalent pixel of the reference image. The rate of false positives is further controlled by applying noise reduction to either or both of the reference image and the sample image.

The reference image may be obtained by averaging source images to obtain a reference image, and the averaging process may depend on the nature of the source images. Where the source images derive from a library of past scans, a large number of (e.g. more than 20, more than 30 or about 35) images may be averaged to obtain the reference image since the averaging can be performed off-line. The source images may be aligned before averaging.

Alternatively, the sample image may be compared to a reference image derived from "live" source images obtained from different parts of the same sample. In this case fewer, e.g. two, source images may be averaged to obtain the reference image. The two source images may be obtained from corresponding regions of different dies of the sample. Alternatively, if the pattern being inspected has a repeating element, the source images may be obtained from the same die. In some cases the source images may be shifted portions of the sample images. In cases where the sample image is compared to a reference image derived from live source images, the roles of the different images may rotate. For example if three images A, B and C are output by a charged particle assessment device: A and B may be averaged to provide a reference image to compare to C; A and C may be averaged to provide a reference image to compare to B; while B and C are averaged to provide a reference image to compare to A.

Another possibility is that the reference image is obtained from one or more "known-good" patterns. Another possibility is that the reference image is obtained by simulation, e.g. based on pattern or design data (e.g. in GDSII format). Such a reference image, at least by a first processing module e.g., in a first step of a two-step process, may be a simplification of the one or more "known-good" patterns or the simulation.

The result of the comparison of a sample image to a reference image may be a simple binary value representing a difference or a correspondence (i.e. matching) between the sample and references images. More desirably, the result of the comparison is a difference value representing the magnitude of the difference between the sample image and the reference image. Desirably, the result of the comparison is a difference value for each pixel (or each group of adjacent pixels which may be referred to a 'region of pixels') so that locations of defects within a source image can be determined greater precision.

To determine if a difference of a pixel or a region of pixels between source image and reference image represents a defect in the pattern being inspected, a threshold may be applied to the difference value corresponding to the pixel or region of pixels. The threshold may be fixed in advance, e.g. for a specific charged particle beam system or for a specific pattern to be inspected. The threshold may be a user-set parameter or by other conditions, for example it is updated from time to time dependent on application or from assessment. The threshold may be determined dynamically, updated during the course of processing, or both. Alternatively, a predetermined number of locations having the highest difference values may be selected as candidate defects for further inspection. Adjacent pixels having difference values higher than a threshold may be considered a single defect or candidate defect. All pixels of a single defect may be ascribed the same difference value. Such adjacent pixels and all pixels of a single defect may be referred to as a region of pixels.

As depicted in **Fig. 3****,** data processing device 500 comprises a filter module 501 which receives and filters a sample image from a charged particle assessment device 41, a reference image generator 503 which generates a reference image based on source images, a comparator 502 which compares the filtered sample image to the reference image and an output module 504 which processes and outputs the result of the comparison.

Filter module 501 applies a filter to the input data, as discussed further below. Filter module 501 is conveniently implemented by dedicated hardware, e.g. an FPGA or an ASIC. Such dedicated hardware can be more efficient and economic than programmed general purpose computing devices such as a standard or common type of CPU architecture. The processor may be less powerful than a CPU, but may have architecture suited to processing software for processing the detection signal data, i.e. the images and so be capable of processing the images in the same or less time than the CPU. Such detected processing architecture, despite having a processing capability lower than most contemporaneous CPUs may be as fast at processing the data because the more efficient data architecture of the dedicated processing architecture. A general purpose CPU can also be used and may be advantageous in providing increased flexibility to alter the filter after manufacture.

The reference image generator 503 may be operable in one or more modes, each mode representing a different approach to generation of the reference image.

In a library mode (also referred to as die-to-database mode), the reference image generator 503 averages a large number of source images obtained from previous scans of patterns nominally the same as the pattern currently being assessed. Such images may have been generated earlier in the same batch of samples, or from samples in previous batches. The library images may be derived from test samples or production samples. Before averaging the images are desirably aligned with one another. Averaging the source images to generate the reference image has the effect of reducing noise. Averaging the source images in this way also averages away any defects that might be visible in the source images. The reference images in the library may comprise synthetic images, e.g. generated by simulation from design data (e.g. GDSII data).

In the case where the pattern being inspected is a repeating pattern it is possible to generate the reference image by averaging a plurality of shifted versions of a source image. Each version of the source image is shifted by integer multiples of the dimensions of the unit cell. If either or both dimensions of the unit cell are not equal to an integer number of pixels, the shift amount can be rounded to the nearest pixel or a fractional pixel shift can be effected by interpolation, for example linear or cubic interpolation, such as bicubic interpolation, or any other known interpolation technique. Another possibility is to shift by a multiple of the pitch of the repeating pattern such that the multiple is an integer number of pixels. In effect, multiple instances of the unit cell are extracted from the source image and averaged. This approach may be referred to as an example of array mode, more specifically of providing a reference image for an array mode.

In a die-to-die mode, a charged particle assessment device is used to generate a sample image and two reference images of similar surface features which may have a repeating pattern. In an arrangement the sample image and each of the two reference images are from different dies of the sample (for example so that similar portions of the surface of different dies may be compared), The sample image may be compared to each of the reference images to identify differences between each of the reference images. Such a difference may be considered as a candidate defect. Differences which are common to the comparison between the sample image and the different reference images are treated as a defect. Differences which are only present in one of the comparisons between the sample image and the different reference images are treated as being a defect in the reference image and not in the sample image. Such defects in the reference image are removed from a group of the candidate defects. An image aligner is provided to align the images before they are supplied to the reference image generator 503 and filter module 501 as appropriate. In an arrangement three columns of a multi-column charged particle assessment device are used to generate the sample image and the two reference images. This arrangement is particularly efficient where the spacing between columns is equal to the die size of the sample being inspected since the columns will then automatically scan corresponding pattern features simultaneously. Using such an arrangement is also faster than using a single column because the sample image and reference images may be acquired simultaneously, In case there is a difference between the column spacing and die size, such as due to variations in the surface position of features on the sample surface, a buffer may be employed to correct the timing of image input to the data processing device.

In an alternative variant of die-to-die mode, the same beam (of the same column in the case of a multi-column system) is used to generate a sample image and two reference images. This has the advantage that column to column and beam to beam corrections are not required and the routing of data can be simplified. For example such a calibration is the relative position of a beam relative to the ideal beam position for that beam or even for each beam. Using the same beam avoids the calibration, e.g. assessment of the offset, between beams for the different scans that are compared. Using the same beam means that although the beam has an offset with respect to the ideal beam position, there is no positional offset to correct for when comparing data retrieved from the scans. However, the need for data buffering might be increased, for example in frequency, if not in quantity of data buffered before the start of the comparison of the data from different dies.

An alternative version of array mode using single column 507, e.g. of a single-column system, provides a sample image which is compared against a reference image derived from two shifted versions of itself as source images. A buffer may be used to provide the shifted images.

With reference again to **Fig. 3**, comparator 502 may be any logic circuit capable of comparing two values, for example an XOR gate or a subtractor. Comparator 502 is also suitable for implementation by dedicated hardware, e.g. an FPGA or an ASIC. Such dedicated hardware can be more efficient and economic than programmed general purpose computing devices, e.g. CPUs. Desirably, comparator 502 is implemented on the same dedicated hardware as filter module 501.

In some cases, the reference image generator 503 can also be implemented in dedicated hardware, especially where the reference image generator operates only in a mode where the reference image is generated from a small number of, e.g. two, source images. In that case it is desirable that the reference image generator is implemented in the same dedicated hardware as the comparator and/or filter module. The mathematical operations to average pixels of source images and compare to a pixel of a sample image can, in suitable cases, be combined into a single logic circuit.

Output module 504 receives the results output by comparator 502 and prepares output to the user, other fab systems or for further processing within the inspection system. The output may be in any of several different forms. In a simplest option, the output may simply be an indication that the sample has or does not have a defect. However, since almost all samples will have at least one potential defect more detailed information is desirable for example as a data set, such as an image (e.g. such as a data set renderable as an image). Therefore the output may comprise, for example, a map of defect locations, a deviation image, an clip of pixel data (for example of the image and the reference image or of the reference image) and/or information as to the severity of a possible defect represented by the magnitude of the difference between the sample image and the reference image, for example how the sample image deviates from the reference image. Output module 504 may also filter the potential defects, e.g. by only outputting defect locations where the magnitude of the difference between the sample image and the reference is greater than a threshold or the density of pixels showing a difference is higher than a threshold. Another possibility is to output only a predetermined number of most serious defect sites, indicated by the magnitude of the difference. This may be effected by storing defect sites in a buffer 510 and, when the buffer is full, overwriting the lowest magnitude defect if a higher magnitude defect is detected.

Any suitable format for the output of defect information may be used, e.g. a list, data set, image or a map. Desirably, output module 504 may output clips, that is images of regions of the sample where potential defects have been detected. This allows the potential defect to be further examined to determine if the defect is real and serious enough to affect operation of the device formed on or present in the sample. The rest of the source image, i.e. those parts not saved as clips, may be discarded to save on data storage and transfer requirements. The data set may thus be a set of clips; the image may comprise the set of clips,

To obtain a two-dimensional image of the sample, the (or each) probe beam is scanned across the surface of the sample. A variety of different scan strategies can be used, e.g. continuous scan, leap scan, or hybrid scanning strategies, in part depending on the number of beams used. For example, a single beam, or each beam of a multi beam, may be scanned in a two-dimensional raster pattern. This involves movement of the beam in two directions: a main scanning direction and a sub-scanning direction. The main scanning direction may be referred to as the fast scan direction. For example the scan deflector may be controlled to actuate the primary beam (e.g. multi-beam) in the fast direction. The sub-scanning direction may be referred to as the slow scan direction. For example the stage maybe controlled to actuate the sample relative to the path of the primary beam; the scan deflector may be controlled to actuate the path of the beam over the sample surface in the slow direction; or both the stage and the scan deflector are actuated to achieve scanning in the slow direction. The stage is preferred to be used only in the slow direction because its inertia due to its large mass, makes achieving the movement of scanning in the fast direction, e.g. acceleration, more challenging than alternatives such as a scan deflector. The ranges of the fast and slow scan directions may be very different.

An embodiment of scanning, for example with slow and fast scanning directions within a field of view of an array of beams of charged particles (for example as a beam grid), which may be referred as a hybrid leap scanning strategy, is disclosed in EPA 21171877.0 filed 3 May 2021. This document is herein incorporated by reference at least so far as the disclosed scanning strategies. Such a scanning strategy steps the stage and thus sample after scanning of the sample surface within a field view of the array of the beams for scanning of a different portion of the sample surface within the field of view of the array of beams. Such a hybrid leap scanning strategy may be suited to an array of beams with a relatively large field of view, for example 1 mm, 5 mm, 10 mm or even 20 mm Such an array of beams may comprise many beams as described herein.

The charged particle assessment system 100 may have a high throughput and a high resolution, meaning that data may be output at a high rate. For example a multi-beam charged particle assessment apparatus, and in particular a multi-column charged particle assessment apparatus, may have up to a hundred, hundreds, thousands, even tens of thousands, of beams or more, with each beam having one or more detector portions outputting data points at a rate of kilo- or mega-Hertz. A high throughput is highly desirable and continuous efforts are made to improve the throughput of charged particle assessment apparatus.

In normal circumstances of some sample inspection processes, the rate of defects in samples undergoing assessment is very low for example in high volume manufacturing. In other words a low proportion of the area of the samples contains defects. Desirably, none or only a few defects would exist on each sample. However, due to a non-negligible false positive rate, there may still be a significant number of candidate defects that require detailed analysis to determine whether or not they are actual defects. Such false positives may appear, at least initially or superficially, to be indistinguishable from the actual defects. The detailed analysis may be computationally intensive, require specific complex algorithms or require human input (for example manual review, which tends to be time consuming). Therefore to improve efficiency and reduce the burden of analysis of candidate defects, it is desirable to reduce the rate of false positives.

The present inventor has determined that a significant proportion of false positives derive from transient error conditions in the functioning of the charged particle assessment apparatus or its environment. Such an event of a transient error condition may be referred to as a transient error, or transient error occurrence. Such false positives may be nuisance signals having a signal magnitude similar to genuine defects. Such nuisance signals may be indistinguishable from defect signals. When a transient error condition occurs, the charged particle assessment apparatus can be considered to be in an error status (or state) for a period of time, which is referred to herein as an error period. The error period, or duration, may be longer than the transient error condition that caused it. When an error event is detected, depending on the nature of the transient error condition, the error period may be considered to have started before the detection of the transient error condition. So the start of the transient error may be considered to have started before the transient error condition (i.e. the detection of the transient error condition). The error duration may be represented by a status signal, e.g. an error status signal.

The status signal may take the form of a log or event stream comprising data indicating the nature of a transient error condition and at least one of: time information indicating the time of the start of the error condition, time information indicating the time of the end of the error condition and the duration information indicating the duration of the transient error condition (The duration of the transient error condition may be implicit in the nature of the transient error condition indicated in the data). As mentioned, the error duration may be of a different duration than the transient error condition that gave rise to it. Alternatively the signal may be a continuously or periodically output signal that indicates the state of the charged particle assessment apparatus at the time the signal is output. The continuously or periodically output signal may be a simple binary signal, e.g. 1 or 0 ( for example indicating "OK" or "Not-OK") or a more complex signal indicating the status of multiple sub-systems, e.g. beams or columns.

Where data detected by a detector (such as detector 240) is compared with the corresponding expected data for a sample without any defects, the difference between the detected data and the expected data may represent a combination of genuine defects and nuisance signals, caused for example by noise. The nuisance signals of the noise are often identified as those signals having a signal strength below a certain threshold value. Signals having a signal strength equal to or greater than the threshold value are considered to be likely defect signals which may then undergo further analysis to determine whether a defect exists and if so to classify the nature of the defect. Transient error conditions may result in signals having a greater strength than a threshold selected to separate noise such as nuisance signals of the noise from genuine defects. The nuisance signals generated by or at the time of transient error conditions may have a magnitude similar to genuine defects so they cannot be filtered out using a threshold. Such nuisance signals can appear to be indistinguishable from the actual defects.

Accordingly, it is possible to identify potential false positives amongst the candidate defects by detecting transient error conditions and correlating the detection of candidate defects with the state of the charged particle assessment apparatus at the time the detection of the candidate defect was performed. Alternatively, it is possible to identify potential false positives amongst the candidate defects in this way when the charged particle assessment apparatus may be in an error status instead of by detecting transient error conditions. Remedial action can then be performed. Remedial action may comprise disregarding any candidate defects that were detected during an error period. Remedial action may be applied to all signals generated by the charged particle assessment apparatus during an error period. In some cases, e.g. where a transient error condition only has a local effect in the charged particle assessment apparatus, remedial action may be applied only to signals derived from a specific feature such as a column, a beam, a signal channel, a signal processor, an data processor or a detector or to a subset of such features such as the columns, beams, signal channels, signal processors, data processors or detectors. Such remedial action may be applied only to signals derived from a specific feature or group of features which are subject to the error condition.

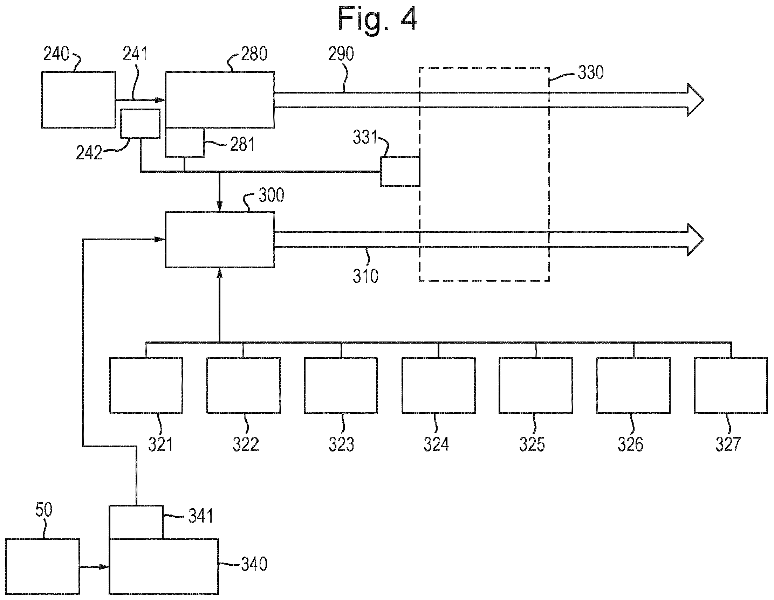

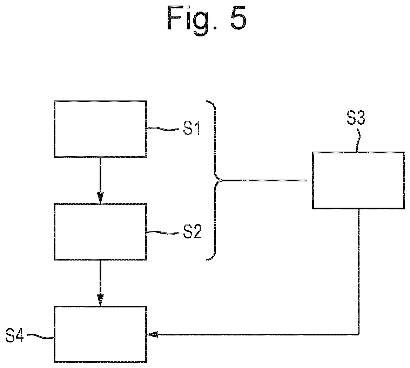

An embodiment of the invention as part of a charged particle assessment apparatus (as an example of an assessment apparatus) for detecting defects in samples by scanning a charged particle beam across a sample is depicted in **Fig. 4**. A flow chart of a method performed by a charged particle assessment system is shown in **Fig. 5**. The assessment apparatus is used to generate S1 assessment signals representing a property of a surface of a sample. In an embodiment, the generation of assessment signals may be a two-step process in which the detector unit 240 first detects charged particles incident from the sample and outputs a detection signal in response thereto. Then a signal processing system 280 pre-processes the detection signal to generate an assessment signal 290, the assessment signal including property information relating to a property of the sample. The pre-processing may be as simple as analog to digital conversion so that the assessment signal simply measures the response of the sample to charged particles directed thereon. The pre-processing may be more complex, e.g. distinguishing between backscatter and secondary electrons. Subsequently, the assessment signal is processed S2 to identify candidate defects and a candidate defect signal is output. The processing to identify candidate defects may be performed by a data processor included in the assessment apparatus or elsewhere. The candidate defect signal may be a selection of a part of the assessment signal.

The assessment signal and the candidate defect signal are linked to a time of detection of the signal particles. Linking the assessment signal and the candidate defect signal to a time may comprise adding a timestamp to each data point or to a predetermined proportion of data points in a datastream. In some cases, the assessment signal and the candidate defect signal may take the form of an image. or other geometrically structured datafile, in which case individual data points may be linked to a time by knowledge of a scanning pattern and rate of scanning used to generate the image and data indicative of the time of a reference point in the scan e.g. its start or end. In the case of a charged particle assessment apparatus that uses multiple beams (or a plurality of beams for example in an array of beams, such as in a beam grid), the assessment signal may also be linked to the beam from which the signal particles have derived. Some or all of the time of detection, timestamp, the time of the reference point in the scan may be time in a timeline, for example of the assessment signal. The timeline may be common to some or all of the sub-systems of the charged particle assessment apparatus or even the charged particle assessment system.

The charged particle assessment apparatus also comprises a status monitor 300 configured to monitor S3 a status of the charged particle assessment apparatus for error conditions and to generate a status signal 310 indicating any error conditions during functioning of the assessment apparatus. The status signal may also be referred to as an error status signal. The status signal may include time information indicating a time, for example in the timeline, that the charged particle assessment apparatus was in an error status. For example, the status monitor may be configured to output an error status signal on the occurrence, for example in the timeline, of one or more events in the charged particle assessment apparatus selected from the group consisting of: abnormal vibration, abnormal electrical discharge; power fluctuation; data processing error; data communication error; gas leak; abnormal temperature fluctuation; and abnormal pressure fluctuation. Such events may have unusual characteristics compared to normal operation. For example an abnormal vibration may be a vibration of a frequency outside the frequencies of vibration that occur during normal vibration and/or a vibration outside the range of magnitude of vibration during normal operation. Some events may be indicative of certain type of event for example a failure such as an electrical discharge for example of electron-optical component in the charged particle device. In some cases, e.g. electrical discharge, any occurrence of the event may be considered an error condition. In other cases, for example a power fluctuation, only an occurrence having a predetermined magnitude and/or duration might be considered an error condition. Other error conditions are of course possible and these error conditions may not be applicable to some types of assessment apparatus. For example pressure fluctuations may not be considered an error state in an optical assessment apparatus which does not operate in vacuum.

Accordingly, the status monitor may comprises one or more sensors selected from the group consisting of: temperature sensors such as thermometers 321; pressure sensors such as barometers or vacuum gauges 322; microphones 323; voltage detectors 324; current detectors 325; and photonic sensors such as light sensors 326 and radio wave detectors 327. Other sensors may include accelerometers and position or displacement measuring systems, e.g. using interferometers or encoder-grid systems. The invention may also make use of existing sensors that are used to monitor parts of the charged particle assessment apparatus, for example sensors to measure beam resolution, beam current, detector noise. Such sensors may normally be used to control parameters of the charged particle assessment apparatus, e.g. in feedback or feedforward loops, but can be configured to generate error signals if, for example, a deviation from expected values that is too large to be compensated for or controlled is detected. An error state considered to have occurred if the moving average or moving standard deviation of a monitored parameter exceeds predetermined bounds.

A temperature sensor such as a thermometer may detect an abnormal variation, for example transient variation, in the temperature of the charged particle assessment apparatus, or a part thereof. The abnormal variation in temperature (or the abnormal thermal variation) may be indicative of an error state such as a malfunction or a failure of the temperature control system of the clean room in which the charged particle assessment apparatus is operating.

A barometer or vacuum gauge 322 may detect an abnormal pressure, for example a transient pressure variation, in the charged particle assessment apparatus, or a part thereof, which may be indicative of an error state such as a malfunction or leak or an electrical discharge, which might release gas from a surface.

A microphone or accelerometer may detect vibrations in the charged particle assessment apparatus, or a part thereof, which may be indicative of an error state such as a malfunction or an external disturbance, such as a transient malfunction or a transient external disturbance, e.g. an earthquake such as a tremor. In the event of such a transient malfunction or disturbance, the error is transitory and the charged particle assessment apparatus continues operating without intervention through the error duration. The charged particle assessment apparatus continues operating after the error period A microphone may detect an unusual pattern of vibration caused by a moving part of the apparatus, e.g. a cable slab rubbing against another component, or by an unexpected collision of two parts. An electrical discharge in the apparatus may also generate a detectable sound. A simple threshold of noise (or sound amplitude or sound frequency as in for example a range of sound frequencies) may be applied to detect error states or more complex signal analysis may be used to distinguish between normal operating sounds and abnormal noise (or sounds such as in amplitude or frequency composition) indicative of a error state.

A voltage detector or a current detector may detect an abnormal voltage, for example a transitory voltage, in the charged particle assessment apparatus, or a part thereof, which may be indicative of an error state such as a discharge. A photonic detector such as a light sensor or radio wave detector may also detect electrical discharges. It is to be noted that the charged particle assessment apparatus has various components operating at high voltages so that electrical discharges are possible and a discharge may be a transient error condition in itself or indicative of another error state.

The signal processing system 280 may comprise an error detector 281 configured to detect errors in processing of the detection signal. Such errors in processing of the detection signal may be transitory errors. The signal processing system 280, for example the error detector, maybe configured to communicate a processing error signal to the status monitor.

A transmission channel 241 transmits the detection signal from the detector unit 240 to the signal processing system 280. A transmission error detector 242, e.g. a checksum, parity check or cyclic redundancy check, is configured to detect errors in transmission of the detection signal. Such a transmission error may be a transitory error. The transmission error detector 242 may be configured to communicate a transmission error signal to the status monitor is optionally provided. Additional transmission error detectors may be provided to detect errors in transmission of other signals.

The charged particle assessment apparatus has controller 50 which generates a control signal for controlling a subsystem 340 of the charged particle assessment apparatus. Optionally, there may be provided an anomaly detector 341 which is configured to detect an anomalous response of the subsystem to the control signal. The anomalous response may be transient error. As a transient error the subsystem may continue operating because the transient error may be temporary. The operation of the subsystem may be unaffected by the transient error. The anomaly detector may be configured to communicate an anomaly signal to the status monitor. The subsystem may comprise an actuated stage configured to support a sample which might fail to move correctly in response to a control signal.

A communication interface 330 may be provided to communicate the assessment signal and the error status signal to an external apparatus, e.g. a data processing apparatus. Any suitable communication system may be used. The signal data derived from the sample may be combined with the state information into a single datastream or may be kept in separate communication channels. Data may be communicated continuously or in batches or packets. Desirably, a communication error detector 331 is provided to detect errors in communication of the assessment signal and to communicate a communication error signal to the status monitor 300.

In an embodiment, the assessment signal comprises a data record that describes a defect candidate on the sample and detection time information, e.g. a time stamp, indicating the time of detection of the defect candidate. For example, the data record comprises an image of a part of the sample having a defect candidate. The data record may be an image of the defect candidate. Such an image may be referred to as a "clip". The image may be derived from the signal returning from the sample or the difference between an image derived from the sample and a reference image. The error status signal comprises information indicating the nature of the error status and the time of occurrence of the error status. In the event of error conditions causing only local errors in the apparatus, for example data processing or communication errors may only affect signals from specific beams or detectors, the error status signal may also indicate the affected parts of the charged particle assessment apparatus (e.g. beam(s), column(s) or signal path(s)).

Data processing apparatus 500 processes the assessment signal which includes property information relating to a property of a sample and status information indicating a status of a charged particle assessment apparatus at the time of generation of the property information. The data processing apparatus includes an analysis unit configured to determine S4 if candidate defects are real defects on the sample based on analysis of the property information of the candidate defect signal. A real defect represents some actual difference in the sample that is of sufficient significance, e.g. to affect operation of a device being formed on the sample. The analysis unit may employ any suitable known technique to determined real defects from false positives amongst the candidate defects.

The analysis unit does not complete analysis of property information generated at a time when the status information indicates the charged particle assessment apparatus was in an error state. By not analyzing property information obtained at a time when the charged particle assessment apparatus was in an error state, computational effort is reduced. Desirably, the analysis of property information is not started if the charged particle assessment apparatus was in an error state at the time of generation of the property information. That is the analysis of a candidate defect is not started if the status signal indicates that the assessment signal(s) corresponding to the candidate defects would have been affected by an occurrence of an error condition. This maximizes the saving of computational effort. In an embodiment, property information generated during an occurrence of an error condition is removed from a stream of data to be analyzed. In an embodiment, analysis of property information generated during an occurrence of an error condition may start but be stopped early, i.e. before completion. This approach may be useful to allow time for determination as to whether or not the status of the charged particle assessment apparatus at the time the detection signal was generated, from which the candidate defect derives, is a an error state. During such an error state, the operation of the charged particle assessment apparatus is likely to be affected such that a candidate defect is likely to be a nuisance signal. Such an approach, of terminating analysis early, permits analysis as to whether or not the candidate defect is likely to be a genuine or real defect without delay.

It is noted that analysis of candidate defects and determination of whether to perform such analysis based on the status signal need not happen contemporaneously with the assessment of samples. The assessment of samples may continue during and after the occurrence of an error condition. If analysis of one or more candidate defects is not started or stopped because of the occurrence of an error condition, the analysis of other candidate defects, e.g. candidate defects generated after the error condition has ceased or generated by parts of the assessment system not affected by the error condition, may continue. A temporary or localized error condition does not result in operation of the assessment system being interrupted. However, an extended and/or non-localized error condition may lead to the operation of the assessment system being halted.

In another aspect of the invention, an error state can be inferred from the property information, given that the probability of a defect is low. A temporal or geometric coincidence of candidate defects may be more likely to have arisen as a result of an error state in the charged particle assessment apparatus than as a result of multiple genuine defects or a large defect. For example, in a multi-beam charged particle assessment apparatus, if property information obtained from several, or even all, beams simultaneously indicate candidate defects it is likely that some common phenomenon has affected several beams rather than that the sample has multiple defects arranged such that they are simultaneously probed by different beams. Defects in a regular pattern might be more likely nuisance than real. As another example, a high rate of candidate defects in property information deriving from a particular subsystem (e.g. a single detector, beam or column in a multi-column apparatus) is likely to derive from an error or fault with that subsystem. For example a high rate of defects associated with a specific beam may indicate beam failure.

Therefore, the analysis unit is desirably configured to analyse the assessment signal to detect correlations between assessment signals generated in response to different charged particle beams, desirably two charged particle beams of the plurality of beams, over time to determine if the pattern of candidate defects is more likely indicative of an error state than of actual defects on samples. A correlation between assessment signals may occur if there are coincident candidate defects. Various approaches to such analysis can be taken. For example it may be sufficient to set thresholds for the number of candidate defects per unit time and/or per group of beams. Such thresholds may be set based on expected defect rates in the samples being assessed and/or historical error rates in the charged particle assessment apparatus. More complex pattern recognition algorithms and well known analysis techniques (e.g. machine learning) can also be used.

Once a failure state has been identified through analysis of candidate defects, remedial action as described above can be taken, for example not processing defects associated with a particular beam or group of beams, for example the detection signal from a detector element associated with a failed beam. In the case of beam failure, it may be desirable to deactivate a failed beam or the detector associated with the failed beam. The beams of the plurality of beams may each have a different beam identity. Each beam may have a unique identify for example with the array of beams. Such a beam identity may be referred to as identity information. The failed beam may be identified by its beam identity. Thus the detection signal and/or detector element may be identified by beam information, for example the beam identity of the failed beam. For example in the case of beam failure it may be possible to "blank" a beam, e.g. by a controller configured to set an electron-optical component such as a scan deflector to divert the failed beam(s) of the beam grid so that it does not reach the sample. Other remedial action as described above, e.g. removal of candidate defects affected by an error condition from a data stream, may also be performed.

Beam failure may be determined before the generation of the assessment signals, desirably such determining is by generating calibration assessment signals and analysing such calibration assessment signals to identify failure of at least one beam of the plurality of beams.

The present invention advantageously addresses error conditions that are transitory, i.e. exist for a short period of time, or localized to specific parts of the charged particle assessment apparatus, e.g. a small number of beams in a multi-beam apparatus. Transitory or local error conditions may be considered to be error conditions that affect the assessment of less than 1%, desirably less than 0.1%, most desirably less than 0.01 % of the area of a sample. Transitory error conditions may last for less than 10 s, desirably less than 1 s, more desirably less than 0.1 s. Desirably, the assessment system or a relevant subsystem thereof may continue operating during or after a transient error because the transient error is temporary. The operation of the subsystem may be unaffected by the transient error, or not affected seriously enough to prevent continued operation.

References to upper and lower, up and down, above and below, etc. should be understood as referring to directions parallel to the (typically but not always vertical) up-beam and down-beam directions of the electron beam or multi-beam impinging on the sample 208. Thus, references to up beam and down beam are intended to refer to directions in respect of the beam path independently of any present gravitational field.

The embodiments herein described may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a sub-beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electro-magnetic field of the compound lens array.

The terms "sub-beam" and "beamlet" are used interchangeably herein and are both understood to encompass any radiation beam derived from a parent radiation beam by dividing or splitting the parent radiation beam. The term "manipulator" is used to encompass any element which affects the path of a sub-beam or beamlet, such as a lens or deflector. References to elements being aligned along a beam path or sub-beam path are understood to mean that the respective elements are positioned along the beam path or sub-beam path. References to optics are understood to mean electron-optics.

An assessment tool or assessment system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools). Such tools and systems may operate optically or electron-optically.

Reference to a component or system of components or elements being controllable to manipulate a charged particle beam in a certain manner includes configuring a controller or control system or control unit to control the component to manipulate the charged particle beam in the manner described, as well optionally using other controllers or devices (e.g. voltage supplies) to control the component to manipulate the charged particle beam in this manner. For example, a voltage supply may be electrically connected to one or more components to apply potentials to the components, such as to the electrodes of the control lens array and objective lens array, under the control of the controller or control system or control unit. An actuatable component, such as a stage, may be controllable to actuate and thus move relative to another components such as the beam path using one or more controllers, control systems, or control units to control the actuation of the component.

The methods of the present invention may be performed by computer systems comprising one or more computers. A computer used to implement the invention may comprise one or more processors, including general purpose CPUs, graphical processing units (GPUs), Field Programmable Gate Arrays (FPGAs), Application Specific Integrated Circuits (ASICs) or other specialized processors. As discussed above, in some cases specific types of processor may provide advantages in terms of reduced cost and/or increased processing speed and the method of the invention may be adapted to the use of specific processor types. Certain steps of methods of the present invention involve parallel computations that are apt to be implemented on processers capable of parallel computation, for example GPUs.

A computer used to implement the invention may be physical or virtual. A computer used to implement the invention may be a server, a client or a workstation. Multiple computers used to implement the invention may be distributed and interconnected via a local area network (LAN) or wide area network (WAN). Results of a method of the invention may be displayed to a user or stored in any suitable storage medium. The present invention may be embodied in a non-transitory computer-readable storage medium storing instructions to carry out a method of the invention. The present invention may be embodied in computer system comprising one or more processors and memory or storage storing instructions to carry out a method of the invention.

Functionality provided by the computers and processors such as the controller or control system or control unit may be computer-implemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. Such computer programs may take the form of multiple computer programs that may be distributed, for example implemented by different processors. The one or more computer programs may be provided in the form of one or more media, optionally non-transitory media, storing computer readable instructions. When the computer readable instructions are read by the computer, the computer performs the required method steps. The computer may consist of a self-contained unit or a distributed computing system having plural different computers connected to each other via a network.

The term "image" used herein is intended to refer to any data structure of values wherein each value relates to a sample of a location and the arrangement of values in the array corresponds to a spatial arrangement of the sampled locations. The term "data map" may be used to describe such a data structure. An image may comprise a single layer or multiple layers. In the case of a multi-layer image, each layer, which may also be referred to as a channel, represents a different sample of the locations. The term "pixel" is intended to refer to a single value of the array or, in the case of a multi-layer image, a group of values corresponding to a single location.

Aspects of the invention are set out in the following numbered clauses.
Clause 1. An assessment method comprising: using an assessment apparatus to generate assessment signals representing a property of a surface of a sample; processing the assessment signals to identify candidate defects and outputting a candidate defect signal; monitoring the status of the assessment apparatus for error conditions and generating a status signal indicating any error conditions during functioning of the assessment apparatus; and analysing the candidate defect signal to determine if the candidate defects are real defects; wherein analysis of a candidate defect is not completed if the status signal indicates that the assessment signal(s) and/or the candidate defect signal corresponding to the candidate defect would have been affected by an error condition.
Clause 2. An assessment method comprising: using an assessment apparatus to generate assessment signals representing a property of a surface of a sample; processing the assessment signals to identify candidate defects and outputting a candidate defect signal; monitoring the status of the assessment apparatus for error conditions and generating a status signal indicating an occurrence of any error conditions during functioning of the assessment apparatus; and analysing the candidate defect signal to determine if the candidate defects are real defects; wherein in analysis of a candidate defect comprises using a status signal to verify that the assessment signal(s) and/or the candidate defect signal corresponding to the candidate defect would have been affected by an error condition and stopping analysis of the defect candidate on verification.
Clause 3. The method of clause 1 or 2 wherein the error conditions comprise one or more of: abnormal vibration, abnormal electrical discharge; power fluctuation; data processing error; data communication error; gas leak; abnormal temperature fluctuation; abnormal pressure fluctuation and abnormal response of a subsystem of the assessment apparatus, desirably such abnormal response being a temporary and/or partial occurrence, desirably the occurrence being such an error condition.
Clause 4. The method of any one of the preceding clauses further comprising generating a control signal for controlling a subsystem of the assessment apparatus; and monitoring the status of the assessment apparatus for error conditions comprises detecting an anomalous response of the subsystem to the control signal, desirably the detecting comprising detecting the occurrence of an anomalous response.
Clause 5. The method of any one of the preceding clauses wherein the status signal comprises time information indicating the time of occurrence of an error condition.
Clause 6. The method of any one of the preceding clauses wherein the status signal comprises duration information indicating the duration of the occurrence.
Clause 7. The method of any preceding clause wherein the assessment apparatus is a charged particle assessment apparatus configured to detect defects in samples by relatively scanning a charged particle beam across a surface of the sample.
Clause 8. The method of clause 7 wherein the charged particle beam is a plurality of charged particle beams, the scanning comprising relatively scanning a surface of the sample and the plurality of charged particle beams and the status signal comprises beam information indicating which of the plurality of charged particle beams is affected by an error condition.
Clause 9. The method of clause 8 wherein the occurrence comprises at least one beam failure desirably amongst the plurality of beams, desirably such an error condition/occurrence is determined before the generation of the assessment signals, desirably such determining is by generating calibration assessment signals and analysing such calibration assessment signals to identify failure of at least one beam of the plurality of beams.
Clause 10. The method of clause 8 or 9 wherein monitoring the status of the assessment apparatus for error conditions comprises detecting correlations between assessment signals generated in response to different charged particle beams, desirably two charged particle beams of the plurality of beams, so as to determine an occurrence.
Clause 11. The method of any of the preceding clauses wherein the assessment signal comprises a data record that describes a candidate defect and detection time information indicating the time of detection of the candidate defect.
Clause 12. The method of clause 11 wherein the data record comprises an image, for example a clip of the image for the defect candidate.
Clause 13. An assessment system comprising: a detector unit configured to generate assessment signals representing a property of a surface of a sample; a data processor configured to process the assessment signals to identify candidate defects and to output a candidate defect signal; a status monitor configured to monitor the status of the assessment system for error conditions and to generate a status signal indicating an occurrence of any error conditions during functioning of the assessment system; and an analysis unit configured to analyse the candidate defect signal to determine if the candidate defects are real defects; wherein the analysis unit is configured to stop analysis of a candidate defect prior to completion if the status signal indicates that the assessment signal(s) and/or the candidate defect signal corresponding to the candidate defect would have been affected by an error condition.
Clause 14. An assessment system comprising: a detector unit configured to generate assessment signals representing a property of a surface of a sample; a data processor configured to process the assessment signals to identify candidate defects and to output a candidate defect signal; a status monitor configured to monitor the status of the assessment system for error conditions and to generate a status signal indicating an occurrence of any error conditions during functioning of the assessment apparatus; and an analysis unit configured to analyse the candidate defect signal to determine if the candidate defects are real defects; wherein the analysis unit is configured to stop analysis of a candidate defect prior to completion if verification using the status signal indicates that the assessment signal(s) and/or the candidate defect signal corresponding to the candidate defect would have been affected by an error condition.
Clause 15. An assessment according to clause 13 or 14 wherein the status monitor comprises one or more sensors selected from the group consisting of: a temperature sensor such as a thermometer; a pressure sensor such as a barometer or vacuum gauge; a microphone; an accelerometer; a position or displacement measuring system; a voltage detector; a current detector; and a photonic sensor such as a light sensor and a radio wave detector.
Clause 16. An assessment system according to clause 13, 14 or 15 wherein the status monitor comprises an error detector configured to detect errors in operation of the data processor.
Clause 17. An assessment apparatus according to clause 13, 14, 15 or 16 further comprising a transmission channel to transmit signals from the detector unit to the signal processor and/or between the signal processor and analysis unit; and wherein the status monitor comprises a transmission error detector configured to detect errors in transmission of the signals.
Clause 18. An assessment apparatus according to any of clauses 13 to 17 further comprising a controller configured to generate a control signal for controlling a subsystem of the assessment system; and wherein the status monitor comprises an anomaly detector configured to detect an anomalous response of the subsystem to the control signal.
Clause 19. An assessment system according to clause 18 wherein the subsystem comprises an actuated stage configured to support a sample.
Clause 20. An assessment system according to any of clauses 13 to 19 comprising a charged particle assessment apparatus configured to detect defects in samples by relatively scanning a charged particle beam across a surface of the sample and desirably comprising the detector unit and the signal processor.
Clause 21. An assessment system according to clause 20 wherein the charged particle assessment apparatus is configured to detect defects in samples by relatively scanning a plurality of charged particle beams across a surface of the sample.
Clause 22. A computer program comprising instructions interpretable by a computer that controls an assessment apparatus, the computer program comprising instructions to perform a method according to any of clauses 1 to 12.
Clause 23. A data processing apparatus for analysing candidate defects to identify real defects, the data processing apparatus comprising: an interface configured to receive from an assessment apparatus a candidate defect signal representing candidate defects and a status signal indicating any error conditions during functioning of the assessment apparatus; an analysis unit configured to analyse the candidate defect signal to identify real defects; wherein the analysis unit is configured to stop analysis of a candidate defect prior to completion if the status signal indicates that the candidate defect signal corresponding to the candidate defect would have been affected by an error condition.
Clause 24. A data processing method for analysing candidate defects to identify real defects, the method comprising: receiving from an assessment apparatus a candidate defect signal representing candidate defects and a status signal indicating any error conditions during functioning of the assessment apparatus; analysing the candidate defect signal to identify real defects; wherein the analysing of a candidate defect is stopped prior to completion if the status signal indicates that the candidate defect signal corresponding to the candidate defect would have been affected by an error condition.
Clause 25. The method of clause 24 wherein the status signal indicates to occurrence of error conditions such as: an anomalous response of a subsystem of the assessment apparatus to a control signal, abnormal vibration, abnormal electrical discharge; power fluctuation; data processing error; data communication error; gas leak; abnormal temperature fluctuation; and abnormal pressure fluctuation.
Clause 26. The method of clause 24 or 25 wherein the status signal comprises time information indicating the time of occurrence of an error condition and/or duration information indicating the duration of the occurrence.
Clause 27. The method of clause 24, 25 or 26 wherein the assessment apparatus uses a plurality of charged particle beams, and the status signal comprises beam information indicating which of the plurality of charged particle beams is affected by an error condition.
Clause 28. The method of any of clauses 24 to 27 wherein the assessment signal comprises a data record that describes a candidate defect and detection time information indicating the time of detection of the candidate defect, desirably the data record comprises an image, for example a clip of the image for the defect candidate.
Clause 29. A computer program comprising instructions interpretable by a computer, the computer program comprising instructions to perform a data processing method according to any of clauses 24 to 28.
Clause 30. A charged particle assessment system for detecting defects in samples by relatively scanning a plurality of charged particle beams, for example in beam grid, and a sample so the grid passes over the surface; the apparatus comprising: detector unit comprising a plurality of detector elements and configured to output a detection signal in response to signal particles incident from a sample resulting from and associated with the different beams of the beam grid; a signal processor configured to process the detection signal to generate an assessment signal, the assessment signal including property information relating to, for each detector element, a property of the sample and a detection time of detection of signal particles; and an analysis unit configured to analyse the assessment signal to identify defect candidates on the sample based on analysis of property information for each detector element in the assessment signal; wherein the analysis unit is configured to analyse the property information from different detector elements to determine an error state associated with one more beams of the beam grid.
Clause 31. The charged particle assessment system of clause 30 wherein the signal processor is configured to assign beam identity information to property information of the assessment signal to identify the detector element from which it was derived.
Clause 32. The charged particle assessment system of clause 30 or 31 wherein the analysis unit is configured to determine, as the error state, failure of a specific beam of the beam grid on the basis of successive candidate defects associated with the specific beam.
Clause 33. The charged particle assessment system of clause 30 or 31 wherein the analysis unit is configured to determine an error state associated with multiple beams on the basis of coincident candidate defects associated with different ones of the plurality of charged particle beams.
Clause 34. The charged particle assessment system of any of clauses 30 to 33 wherein the analysis unit is configured to stop analysis of property information derived from a detector element of the plurality of detector elements for which the respective beam has been associated with an error state.
Clause 35. The charged particle assessment system of any of clauses 30 to 33 wherein the data processor is configured to stop processing the detection signal derived from a detector element of the plurality of detector elements for which the respective beam has been associated with an error state.
Clause 36. The charged particle assessment system of any of clauses 30 to 33 wherein the analysis unit or wherein the data processor is configured to remove from the assessment signal property information derived from a detector element of the plurality of detector elements for which the respective beam has been associated with an error state.
Clause 37. The charged particle assessment system of any of clauses 30 to 33 further comprising a controller configured to control the detector unit to deactivate a detector element of the plurality of detector elements for which the respective beam has been associated with an error state.
Clause 38. The charged particle assessment system of any of clauses 30 to 37 further comprising a charged particle device configured to direct the beam grid towards the sample and a controller configured to control the charged particle device to blank each of the beams which has been associated with an error state.
Clause 39. A method for detecting defects in samples in a charged particle assessment apparatus for projecting a charged particle beam towards a sample, the method comprising: relatively scanning a charged particle beam and a surface of a sample so the beam passes over the surface in the charged particle assessment apparatus; outputting a detection signal from a detector of the charged particle assessment apparatus in response to signal particles from a sample, the detection signal having a time record relative to a timeline; emitting a status signal having a time stamp relative the timeline, the status signal indicating a status of the charged particle assessment apparatus, the status comprising a transient error affecting operation of the assessment apparatus; processing the detection signal when the time record indicates a different time than the time stamp of the transient error.
Clause 40. A charged particle assessment system for detecting defects in samples by relatively scanning a plurality of charged particle beams in beam grid and a sample so the grid passes over the surface; the apparatus comprising: a detector unit comprising a plurality of detector elements and configured to output a detection signal in response to signal particles incident from a sample resulting from and associated with the different beams of the beam grid; a controller configured to control the charged particle assessment system to determine failure of one more beams of the beam grid and identifying the beam identify of the failed beams; and based on the beam identity of the failed beams removing the detection signals of failed beams, or information derived from the detection signals of failed beams, from processing and/or analysing for determining candidate defects on the sample surface.
Clause 41. A method for detecting defects in samples in a charged particle assessment apparatus for projecting a charged particle beam towards a sample, the method comprising: relatively scanning a charged particle beam and a surface of a sample so the beam passes over the surface in the charged particle assessment apparatus; outputting a detection signal from a detector of the charged particle assessment apparatus in response to signal particles from a sample, the detection signal having a time record relative to a timeline; emitting a status signal having a time stamp relative the timeline, the status signal indicating a status of the charged particle assessment apparatus, the status comprising a transient error affecting operation of the assessment apparatus; processing the detection signal when the time record indicates a different time than the time stamp of the transient error.
Clause 42. The method of clause 41, wherein the transient error is a temporary event.
Clause 43. The method of clause 41 or 42, wherein the scanning continues during the transient error.
Clause 44. The method of any of clauses 41 to 43,wherein the processing continues after the temporal event.
Clause 45. The method of any of clauses 41 to 44, wherein the time record is the time of detection of the detection signal.
Clause 46. A charged particle assessment system for detecting defects in samples by relatively scanning a plurality of charged particle beams in beam grid and a sample so the grid passes over the surface; the apparatus comprising: a detector unit comprising a plurality of detector elements and configured to output a detection signal in response to signal particles incident from a sample resulting from and associated with the different beams of the beam grid; a controller configured to control the charged particle assessment system to determine failure of one more beams of the beam grid and identifying the beam identify of the failed beams; and based on the beam identity of the failed beams removing the detection signals of failed beams, or information derived from the detection signals of failed beams, from processing and/or analysing for determining candidate defects on the sample surface.
Clause 47. An assessment method comprising: using an assessment apparatus to generate assessment signals representing a property of a surface of a sample; processing the assessment signals to identify candidate defects and outputting a candidate defect signal; monitoring the status of the assessment apparatus for error conditions and generating a status signal indicating an occurrence of any error conditions and an operational status otherwise, the occurrence occurring during functioning of the assessment apparatus that would have affected an assessment signal generated during the occurrence and/or the candidate defect signal corresponding to the candidate defect and being derived from the assessment signal; and analysing the candidate defect signal to determine if the candidate defects are real defects; wherein analysis of a candidate defect is completed only if the status signal indicates an operational status.
Clause 48. An assessment system comprising: a detector unit configured to generate assessment signals representing a property of a surface of a sample; a data processor configured to process the assessment signals to identify candidate defects and to output a candidate defect signal; a status monitor configured to monitor the status of the assessment system for error conditions and to generate a status signal indicating an occurrence of any error conditions and an operational status otherwise, the occurrence occurring during functioning of the assessment apparatus that would have affected an assessment signal generated during the occurrence and/or the candidate defect signal corresponding to the candidate defect and being derived from the assessment signal; and wherein the analysis unit is configured to complete analysis of a candidate defect only if the status signal indicates an operational status.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses herein.

## Claims

1. An assessment method comprising:
using an assessment apparatus to generate assessment signals representing a property of a surface of a sample;
processing the assessment signals to identify candidate defects and outputting a candidate defect signal;
monitoring the status of the assessment apparatus for error conditions and generating a status signal indicating an occurrence of any error conditions during functioning of the assessment apparatus; and
analysing the candidate defect signal to determine if the candidate defects are real defects;
wherein in analysis of a candidate defect comprises using a status signal to verify that the assessment signal(s) and/or the candidate defect signal corresponding to the candidate defect would have been affected by an error condition and stopping analysis of the defect candidate on verification.

2. The method of claim 1 wherein the error conditions comprise one or more of: abnormal vibration, abnormal electrical discharge; power fluctuation; data processing error; data communication error; gas leak; abnormal temperature fluctuation; abnormal pressure fluctuation and abnormal response of a subsystem of the assessment apparatus, desirably such abnormal response being a temporary and/or partial occurrence, desirably the occurrence being such an error condition.

3. The method of claim 1 or 2 further comprising generating a control signal for controlling a subsystem of the assessment apparatus.

4. The method of the preceding claims further comprising monitoring the status of the assessment apparatus for error conditions comprises detecting an anomalous response of the subsystem to the control signal, desirably the detecting comprising detecting the occurrence of an anomalous response.

5. The method of any preceding claims wherein the status signal comprises time information indicating the time of occurrence of an error condition.

6. The method of any preceding claims wherein the status signal comprises duration information indicating the duration of the occurrence.

7. The method of any preceding claim wherein the assessment apparatus is a charged particle assessment apparatus configured to detect defects in samples by relatively scanning a charged particle beam across a surface of the sample.

8. The method of claim 7 wherein the charged particle beam is a plurality of charged particle beams, the scanning comprising relatively scanning a surface of the sample and the plurality of charged particle beams and the status signal comprises beam information indicating which of the plurality of charged particle beams is affected by an error condition.

9. The method of claim 8 wherein the occurrence comprises at least one beam failure desirably amongst the plurality of beams, desirably such an error condition/occurrence is determined before the generation of the assessment signals, desirably such determining is by generating calibration assessment signals and analysing such calibration assessment signals to identify failure of at least one beam of the plurality of beams.

10. The method of claim 8 or 9 wherein monitoring the status of the assessment apparatus for error conditions comprises detecting correlations between assessment signals generated in response to different charged particle beams, desirably two charged particle beams of the plurality of beams, so as to determine an occurrence.

11. The method of any of the preceding claims wherein the assessment signal comprises a data record that describes a candidate defect and detection time information indicating the time of detection of the candidate defect.

12. The method of claim 11 wherein the data record comprises an image, for example a clip of the image for the defect candidate.

13. An assessment system comprising:
a detector unit configured to generate assessment signals representing a property of a surface of a sample;
a data processor configured to process the assessment signals to identify candidate defects and to output a candidate defect signal;
a status monitor configured to monitor the status of the assessment system for error conditions and to generate a status signal indicating an occurrence of any error conditions during functioning of the assessment apparatus; and
an analysis unit configured to analyse the candidate defect signal to determine if the candidate defects are real defects;
wherein the analysis unit is configured to stop analysis of a candidate defect prior to completion if verification using the status signal indicates that the assessment signal(s) and/or the candidate defect signal corresponding to the candidate defect would have been affected by an error condition.

14. An assessment apparatus according to claim 13 further comprising a controller configured to generate a control signal for controlling a subsystem of the assessment system, wherein the status monitor comprises an anomaly detector configured to detect an anomalous response of the subsystem to the control signal.

15. An assessment system according to claim 13 or 14 comprising a charged particle assessment apparatus configured to detect defects in samples by relatively scanning a charged particle beam across a surface of the sample and desirably comprising the detector unit and the signal processor.
